(19) Europäisches Patentamt
European Patent Office
Office européen des brevets

(11) **EP 3 792 047 A2**

(12) **EUROPÄISCHE PATENTANMELDUNG**

(43) Veröffentlichungstag:
**17.03.2021 Patentblatt 2021/11**

(51) Int Cl.:
**B29D 11/00** (2006.01) **H01L 33/54** (2010.01)

(21) Anmeldenummer: **20185832.1**

(22) Anmeldetag: **14.07.2020**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **12.09.2019 EP 19196944**

(71) Anmelder: **Technische Hochschule Wildau**
**15745 Wildau (DE)**

(72) Erfinder:
• **Dr. Bauer, Joachim**
**12524 Berlin (DE)**
• **Gutke, Marko**
**14167 Berlin (DE)**
• **Edling, Matthias**
**15370 Petershagen (DE)**
• **Prof. Dr. Schrader, Sigurd**
**10405 Berlin (DE)**
• **Prof. Dr. Gerhard, Christoph**
**37136 Ebergötzen (DE)**

(74) Vertreter: **Heinemeyer, Karsten**
**AdvInno Patent-u. Rechtsanwaltspart. mbB**
**Heinemeyer & Joachim**
**Sandstrasse 17-23**
**23552 Lübeck (DE)**

(54) **VERFAHREN ZUR HERSTELLUNG ASYMMETRISCHER LINSEN SOWIE LEUCHTEINHEIT MIT EINER DERART HERGESTELLTEN LINSE**

(57) Beschrieben wird Verfahren zur Herstellung asymmetrischer Linsen (1) sowie eine Leuchteinheit mit einer derart hergestellten Linse. Bei dem Verfahren wird wenigstens ein polymerhaltiges Medium (3) in einem für einen Durchtritt oder eine Emission von Strahlung vorgesehenen Bereich eines Substrats (2) auf das Substrat (2) unter Bildung eines Formkörpers (4) aufgebracht und das polymerhaltige Medium zumindest zeitweise getrocknet und/oder gehärtet.

Die beschriebene technische Lösung zeichnet sich dadurch aus, dass das Substrat (2) bevor, während und/oder nachdem das noch nicht vollständig getrocknete oder ausgehärtete Medium (3) auf das Substrat (2) aufgebracht wird, derart mit dem Substrat gekippt wird, dass ein zwischen einer in Lotrichtung verlaufenden Geraden und einem senkrecht zur Substratoberfläche ausgerichteter Normalenvektor angeordneter Kippwinkel einen Wert zwischen 0° und 90° annimmt oder das Substrat gemeinsam mit dem Medium wenigstens zeitweise in eine Drehbewegung versetzt wird.

Fig.4a

EP 3 792 047 A2

**(Forts. nächste Seite)**

# Fig.4b

# Fig.4c

**Beschreibung**

Die Erfindung betrifft ein Verfahren zur Herstellung asymmetrischer Linsen sowie eine Leuchteinheit mit einer derart hergestellten Linse. Zur Herstellung einer asymmetrischen Linse wird ein polymerhaltiges Medium in einem für einen Durchtritt oder eine Emission von Strahlung vorgesehenen Bereich eines Substrats auf das Substrat unter Bildung eines Formkörpers aufgebracht und das polymerhaltige Medium zumindest zeitweise getrocknet und/oder gehärtet.

Allgemein sind aus dem Stand der Technik unterschiedliche Arten von Polymerlinsen bekannt. Die bekannten Polymerlinsen werden entweder nach der Herstellung in hierfür vorgesehene optische Aufbauten integriert oder aber direkt auf Lichtquellen, die sich beispielsweise auf Halbleitersubstraten befinden, angeordnet. In diesem Zusammenhang sind als LED-Chips ausgeführte Lichtquellen bekannt, die mithilfe geeigneter Polymerbeschichtungen vor Umwelteinflüssen geschützt werden und durch Kombination mit Strahlformungsoptiken über die gewünschte Abstrahlcharakteristik verfügen.

Grundsätzlich lassen sich die für optische Zwecke verwendete Linsen in symmetrische und asymmetrische Linsen unterteilen, wobei asymmetrische Linsen über brechende Oberflächen mit nicht rotationssymmetrischen Krümmungsradien verfügen.

Im Weiteren werden Linsen in sphärische und asphärische Linsen eingeteilt, wobei sich asphärische Linsen dadurch auszeichnen, dass diese über wenigstens eine brechende Oberfläche verfügen, deren Form von der Kugelform oder planen Form abweicht, sodass wenigstens eine Oberfläche vorgesehen ist, deren Krümmungsradius nicht konstant ist und üblicherweise von der Mitte zum Rand hin abnimmt. Sphärische und asphärische Linsen können symmetrisch oder asymmetrisch ausgeführt sein.

Mithilfe asphärischer Linsen ist es durch geeignete Ausführung der Linse möglich, die sphärische Aberration, die Grund für die unscharfe Fokussierung symmetrischer Linsen ist, zumindest zu minimieren.

Verschiedene Verfahren zur Herstellung symmetrischer optischer Linsen sind etwa aus den Dokumenten US 2018/0143414 A1, US 2013/0056774 A1 sowie US 2007/0155033 A1 bekannt. Für eine Reihe von Anwendungen werden allerdings bedarfsgerecht geformte asymmetrische optische Linsen benötigt.

Oftmals werden spezielle asymmetrische Linsen für Leuchteinheiten, wie sie beispielsweise in Straßenlaternen, Fassadenbeleuchtungen, LED-Leuchten und bei Beleuchtungssystemen für Fahrzeuge zum Einsatz kommen, verwendet, um die Abstrahlcharakteristik gezielt zu beeinflussen, insbesondere das ausgesendete Licht in eine bestimmte Richtung zu lenken. Ebenso werden asymmetrische Linsen zur gezielten Lichtverteilung in der Medizintechnik, beispielsweise für UV-LED-Desinfektionsgeräte oder für Lichttherapiesysteme eingesetzt. Regelmäßig ist es hierbei in Abhängigkeit des Einsatzgebietes, so vor allem in der Fahrzeugtechnik, erforderlich, die verwendeten Leuchtmittel auf angemessene Weise und mit geeigneten Materialien zu verkapseln.

Generell ist es bekannt, dass Polymerlinsen, für die zuvor beschriebenen Anwendungen geeignet sind, wobei die Linsen mithilfe von Spritzguss-, Präge- oder 3D-Druckverfahren hergestellt werden.

In diesem Zusammenhang ist beispielsweise aus der US 2013/0056774 A1 ein Verfahren zur Herstellung von asphärischen Polymerlinsen bekannt, die geeignet sind, um auf Halbleiterchips angeordnete LEDs zu verkapseln. Das beschriebene Herstellungsverfahren beruht darauf, dass ein polymerhaltiges Medium im Bereich einer LED auf den Halbleiterchip aufgebracht und der Chip schließlich um 180° gedreht wird, sodass die Erdanziehungskraft auf das Material wirkt und sich nach vollständiger Austrocknung des Materials eine spezielle asphärische Linse ausbildet.

Ferner ist aus der EP 3 460 538 A1 ein Verfahren sowie eine Vorrichtung zur Herstellung von Mikrolinsen bekannt. Das beschriebene Verfahren beruht darauf, dass in einen Bereich eines Halbleitersubstrats, in dem eine Aussparung für eine Linse vorgesehen ist, ein formbares Material aufgebracht wird und durch Prägen mittels eines oberen und eines unteren Linsenstempels eine Linse in das Halbleitersubstrat eingeformt wird. Gemäß der beschriebenen technischen Lösung dient das Halbleitersubstrat selbst als Abstandhalter zwischen dem oberen und dem unteren Linsenstempel, sodass der Prägevorgang auf einen definierten Bereich begrenzt wird.

Im Weiteren ist aus "Umut T. Sanli et. al.; 3D Nanoprinted Plastic Kinoform X-Ray Optics; in: Advanced Materials; 2018, 30, 201802503" ein Herstellungsverfahren bekannt, um Polymerlinsen, die für die Röntgenmikroskopie verwendet werden, mithilfe eines 3D-Druckverfahrens zu erzeugen. Wesentlich bei der beschriebenen technischen Lösung ist, dass als zu druckendes Medium ein Polymer mit besonders günstigen röntgenoptischen Eigenschaften ausgewählt wird und in Abhängigkeit der benötigten optischen Eigenschaften auf der Linsenoberfläche im Wege des 3D-Druckvorgangs spezielle Konturen im Nanometerbereich eingeformt.

Im Übrigen ist aus der US 2006/0291065 A1 ein Verfahren zur Herstellung asymmetrischer Linsen bekannt. Wesentlich an der beschriebenen technischen Lösung ist, dass die Linsen in noch nicht ausgehärtetem Zustand in eine Position überführt werden, in der der Normalenvektor einer Substratoberfläche, auf der die Linse angeordnet ist, nach unten und somit zumindest schräg in Richtung der Erdoberfläche zeigt. Der Winkel zwischen dem Normalenvektor und der Lotrichtung, also der örtlichen Richtung der Erdbeschleunigung nimmt hierbei stets einen Wert an, der kleiner als 90° ist. Aus dieser Anordnung resultiert eine Ablösungstendenz des auf die Substratoberfläche aufgebrachten, erst während der Herstellung aushärtenden Materials, sodass das beschriebene Herstellungsverfahren in Bezug auf die Materialauswahl und die herstellbaren Linsengeometrien beschränkt ist.

Problematisch an den aus dem Stand der Technik bekannten Verfahren zur Herstellung asymmetrischer Polymerlinsen ist, dass die bekannten Verfahren einen vergleichsweise hohen apparativen Aufwand erfordern oder relativ viel Zeit in Anspruch nehmen. Im Übrigen sind die bekannten Verfahren in der Regel jeweils auf die Herstellung speziell ausgebildeter Linsen und/oder die Verwendung besonderer Polymermaterialien begrenzt, sodass sich die flexible Herstellung unterschiedlicher Linsenformen in kurzer zeitlicher Abfolge oftmals nur verhältnismäßig schwierig realisieren lässt.

Ausgehend von den aus dem Stand der Technik bekannten Verfahren zur Herstellung von asymmetrischen Polymerlinsen und den zuvor geschilderten Problemen liegt der Erfindung die Aufgabe zu Grunde, ein Herstellungsverfahren anzugeben, das eine flexible und kostengünstige Herstellung unterschiedlich geformter asymmetrischer Linsen ermöglicht. Gleichzeitig sollte sichergestellt sein, dass mit dem anzugebenden Verfahren sowohl einzelne Linsen als auch Anordnungen mit einer Mehrzahl von Linsen auf einfache Weise herstellbar sind. Die hergestellten Linsen sollten sich ferner auf besonders vorteilhafte Weise sowohl zur direkten Aufbringung auf Halbleitersubstrate oder Lichtleiter als auch zur Verkapselung von Lichtquellen, insbesondere von auf Halbleitersubstraten angeordneten LEDs, eignen. Ebenso sollten die mit dem anzugebenden Verfahren hergestellten Linsen geeignet sein, um im Rahmen der Chip-on-Board (CoB)-Technologie, bei der LED-Chips direkt auf eine Leiterplatte aufgesetzt und mit Hilfe von Bonddrähten kontaktiert werden, verwendet zu werden, und zwar unabhängig davon, ob die Gehäuse Keramik oder Leiterplattenmaterial aufweisen. Im Weiteren sollten ohne wesentlichen Mehraufwand asymmetrische oder asphärische Linsen herstellbar sein, die sowohl zur gezielten Lichtverteilung als auch zur spezifischen Farbgestaltung des ausgesendeten Lichts genutzt werden können.

Ferner sollten Linsen oder Mikrolinsen herstellbar sein, die in optische Systeme eingebaut oder auf LEDs aufgeklebt werden können. Auch die Herstellung geeigneter Linsenarrays mit transparenten Substraten sollte möglich sein.

Der Erfindung liegt ferner ebenso die Aufgabe zugrunde, eine Leuchteinheit anzugeben, deren Abstrahlcharakteristik auf besonders einfache Weise spezifisch an den jeweiligen Bedarf angepasst werden kann, wobei der Aufwand für die konstruktive Gestaltung der Leuchteinheit und die Anforderungen an die benötigten Komponenten möglichst gering sowie die Anordnung der optischer Bauelemente vergleichsweise einfach sein sollten. Die Herstellung einer entsprechenden Leuchteinheit sollte im Vergleich zu den aus dem Stand der Technik bekannten Lösungen vor allem zeit- und kostensparend sein. Wesentlich ist es im Weiteren, dass die basierend auf der Erfindung hergestellten Linsen sowie Leuchteinheiten, insbesondere für den Einsatz in der Fahrzeugtechnik, in Straßen- und Gebäudebeleuchtungen und auch für den Einsatz in der Medizintechnik und für Flat-Panel-Beleuchtungen geeignet sind.

Die vorstehende Aufgabe wird mit einem Verfahren zur Herstellung asymmetrischer Linsen gemäß Anspruch 1 gelöst. Eine Leuchteinheit, die die zuvor beschriebene Aufgabe löst, ist im Anspruch 13 angegeben. Vorteilhafte Ausführungsformen der Erfindung sind Gegenstand der abhängigen Ansprüche und werden in der folgenden Beschreibung unter teilweiser Bezugnahme auf die Figuren näher erläutert.

Die Erfindung betrifft zunächst ein Verfahren zur Herstellung asymmetrischer Linsen, bei dem wenigstens ein polymerhaltiges Medium in einem für einen Durchtritt oder eine Emission von Strahlung vorgesehenen Bereich eines Substrats auf das Substrat unter Bildung eines Formkörpers aufgebracht wird und das polymerhaltige Medium zumindest zeitweise getrocknet und/oder gehärtet wird. Erfindungsgemäß zeichnet sich das Herstellungsverfahren dadurch aus, dass das Substrat bevor, während und/oder nachdem das noch nicht vollständig getrocknete oder ausgehärtete, und damit noch formbare Medium auf das Substrat aufgebracht wird, derart mit dem Substrat gekippt wird, dass ein Kippwinkel, also ein Winkel zwischen einer in Lotrichtung verlaufenden Geraden und dem Normalenvektor der Substratoberfläche, einen Wert zwischen 0° und 90°, vorzugsweise zwischen 30° und 60° und ganz besonders bevorzugt zwischen 40° und 50°, annimmt oder das Substrat gemeinsam mit dem Medium wenigstens zeitweise in eine Drehbewegung, vorzugsweise mit einer Drehachse, die senkrecht zur Substratoberfläche angeordnet ist, versetzt wird.

Die Drehung des Substrats gemeinsam mit dem zu formenden Medium erfolgt vorzugsweise während die Substratoberfläche, auf der das Material oberhalb der Substratoberfläche angeordnet ist, horizontal ausgerichtet ist.

Wesentlich an der beschriebenen Lösung ist, dass die Formgebung wenigstens zeitweise erfolgt, indem eine resultierende Kraft auf das Medium einwirkt, deren Kraftvektor bei einer Drehbewegung oder Kippbewegung schräg zu einer in Lotrichtung verlaufenden Geraden angeordnet ist. Diese auf das Medium wirkende Kraft resultiert aus einem Teil der Schwerkraft oder einer drehungsbedingten Zentrifugalkraft. Wesentlich für die Erfindung ist somit, dass sich die Erdbeschleunigung bzw. die hieraus resultierende Schwerkraft adhäsionsverstärkend für die Verbindung zwischen Substrat und zu formendem Medium auswirkt. Demgegenüber wirkt die Schwerkraft bei den aus dem Stand der Technik bekannten Lösungen, bei denen die Substratoberfläche um mehr als 90° gegenüber der horizontalen Ausgangsposition gekippt wird, sodass das formgebende Material nach unten hängt, entgegen der Adhäsionskraft und somit adhäsionsmindernd.

Ein Vorteil der erfindungsgemäßen technischen Lösung besteht darin, dass eine Linsenform bedarfsgerecht durch gezielte Auswahl eines Polymers und/oder eines Substrats unter Berücksichtigung der jeweils polymer- und/oder substratspezifischen Oberflächenspannung erzeugbar ist. Die Form einer asymmetrischen Polymerlinse lässt sich so unter Berücksichtigung des sich jeweils zwischen Substratoberfläche und Polymer ausbildenden Randwinkels einstellen. Auf diese Weise können speziell geformte asymmetrische Polymerlinsen auf Substraten hergestellt werden, wie es bei den aus dem Stand der Technik bekannten Verfahren nicht möglich wäre, da die nach unten hängenden Linsen aufgrund einer reduzierten Adhäsion zum Substrat zum Abrollen oder Abtropfen neigen.

Gemäß der erfindungsgemäßen Lösung wird das Substrat mit dem darauf aufgebrachten Medium somit in eine Formgebungsposition bewegt und hierdurch wenigstens zeitweise eine Formgebungskraft in das auf das Substrat aufgebrachte Medium eingeleitet, deren Wirkrichtung von der Richtung der Erdbeschleunigung abweicht. Erfindungswesentlich ist hierbei, dass die gewünschte Formgebung des wenigstens einen, noch nicht vollständig getrockneten oder ausgehärteten polymerhaltigen Mediums erfolgt, indem gezielt eine Kraft in dieses eingeleitet wird, deren Wirkrichtung von der Lotrechten oder Lotrichtung abweicht. Es wird somit gezielt eine Kraft in das polymerhaltige Medium eingeleitet, die eine besonders geeignete und an den jeweiligen Bedarf flexibel anpassbare Formung des polymerhaltigen Materials und somit die Herstellung bedarfsgerecht angepasster asymmetrischer Linsen ermöglicht. Die Einleitung einer Kraft, deren Wirkrichtung von der Lotrechten oder Lotrichtung, also der örtlichen Richtung der Erd- oder Schwerebeschleunigung, abweicht, hat hierbei den Vorteil, dass gezielt unterschiedliche asymmetrische Linsenformen in Abhängigkeit der gewünschten Eigenschaften einer Linse in Bezug auf eine Lichtverteilung und/oder Farbgebung eingestellt werden können. Generell ist es in diesem Zusammenhang unerheblich, ob eine oder eine Mehrzahl von Linsen gleichzeitig hergestellt wird.

Bei dem erfindungsgemäß vorgesehenen Substrat handelt es sich allgemein um ein Element, das eine für die Aufbringung des polymerhaltigen Mediums geeignete Oberfläche aufweist, wobei die Oberfläche eben sein und/oder eine Struktur und/oder Kontur aufweisen kann. Insbesondere ist es denkbar, dass das Substrat entweder ein Halbleitermaterial aufweist und beispielsweise als Halbleitersubstrat bzw. Halbleiterwafer ausgebildet ist. Ebenso ist es denkbar, dass das Substrat als Träger, bevorzugt mit einer geeigneten Oberflächenkontur, ausgeführt und geeignet ist, um optische Bauteile und/oder elektronische Halbleiterbauelemente, wie etwa LEDs, aufzunehmen. Bevorzugt ist ein derartiger Träger derart gestaltet, dass er wenigstens ein Gehäuse bzw. eine Einhausung für ein optisches Bauteil und/oder elektronisches Halbleiterbauelement bereitstellt. Auf besonders vorteilhafte Weise ist es in diesem Zusammenhang denkbar, dass ein derartiges Gehäuse oder Einhausung, in dem ein optisches Bauteil und/oder elektronisches Halbleiterbauelement angeordnet ist, wenigstens bereichsweise, vorzugsweise vollständig, von einer erfindungsgemäß hergestellten Linse überdeckt wird. In Abhängigkeit der Einsatzzweckes wird das Material, das das Substrat aufweist, gewählt, wobei gemäß einer speziellen Ausgestaltung das Substrat teilweise oder vollständig aus transparentem und/oder transluzentem Material gebildet wird.

Die Einleitung einer entsprechend geeigneten Kraft erfolgt, indem das Substrat bevor, während und/oder nachdem das noch nicht vollständig getrocknete oder ausgehärtete polymerhaltige Medium auf die Substratoberfläche aufgebracht wird auf geeignete Weise bewegt wird. Bei der Bewegung in eine Formgebungsposition, die durch Kippen oder Drehen des Substrats gemeinsam mit dem noch nicht vollständig ausgehärteten Medium bewirkt wird, kann es sich um eine einmalige Bewegung handeln oder aber es kann eine Mehrzahl von Bewegungen, insbesondere von periodisch wiederkehrenden Bewegungen, zur Formung der gewünschten asymmetrischen Linse vorgesehen seien. Die Krafteinleitung erfolgt bevorzugt derart, dass das Substrat, auf dem das Medium bereits angeordnet ist oder auf dem das Medium angeordnet werden soll, in die wenigstens eine Formgebungsposition bewegt wird und das polymerhaltige Material während oder nach dieser Bewegung derart austrocknet oder ausgehärtet, dass eine weitere, ungewünschte Verformung unterbleibt.

In einer besonderen Ausführungsform der Erfindung ist vorgesehen, dass eine Oberfläche des Substrats, auf dem das Medium bereits angeordnet ist oder auf dem das Medium angeordnet werden soll, zumindest zeitweise während oder nach der Aufbringung des Mediums derart relativ zu einer durch das Substrat verlaufenden Lotrechten, also in Lotrichtung verlaufenden Geraden, geneigt wird, dass eine Ebene, in der die Oberfläche des Substrats angeordnet ist und die Lotrechte einen Kippwinkel, der zwischen 0° und 90°, bevorzugt zwischen 30° und 60° und ganz besonders bevorzugt zwischen 40° und 50° liegt, einschließen. Eine in Lotrichtung verlaufende Gerade und ein auf die Oberfläche des Substrats senkrecht stehender Normalenvektor schließen somit einen Kippwinkel, der zwischen 0° und 90°, bevorzugt zwischen 30° und 60° und ganz besonders bevorzugt zwischen 40° und 50° liegt, ein. Die gezielte Einleitung einer Kraft erfolgt gemäß dieser Ausführungsform somit dadurch, dass sich das Substrat mit dem darauf angeordneten noch nicht vollständig ausgehärteten oder getrockneten polymerhaltige Medium in einer gekippten Formgebungsposition befindet, wobei eine asymmetrische Linse dadurch hergestellt wird, dass eine resultierende Kraft auf das Medium wirkt, die unmittelbar nach Aufbringung des Mediums auf das Substrat eine asymmetrische Verformung des aus dem Medium gebildeten Formkörpers in einer Vorzugsrichtung bewirkt. Vor oder während das auf die Substratoberfläche aufgebrachte Medium aushärtet oder austrocknet wird das Substrat somit gezielt gekippt, so dass der zunächst beispielsweise tropfenartige Formkörper in die gewünschte asymmetrische Linsenform überführt wird. In diesem Zusammenhang ist es generell denkbar, vor, während und/oder nachdem das Substrat gekippt wird, entweder in einem Bereich oder wenigstens zwei Bereichen eines Substrates Medium unter Ausbildung von Formkörpern, insbesondere von tropfenartigen Formkörpern, aufzubringen, sodass zeitgleich wahlweise eine asymmetrische Linse oder eine linien- oder arrayförmige Anordnung von Polymerlinsen erzeugbar ist.

Vorzugsweise wird der Kippwinkel in Abhängigkeit der gewünschten Abstrahlcharakteristik oder Farbgebung gewählt. In diesem Fall kann wiederum berücksichtigt werden, dass entweder nur eine oder eine Mehrzahl von Linsen gleichzeitig durch eine geeignete Kippbewegung erzeugt wird.

Gemäß einer besonderen Ausführungsform der Erfindung ist somit vorgesehen, dass in wenigstens zwei Bereichen des Substrates gleiches Medium oder unterschiedliche Eigenschaften aufweisendes Medium, jeweils unter Ausbildung von Formkörpern auf das Substrat aufgebracht wird und die wenigstens zwei jeweils vom Medium gebildeten Formkörper gemeinsam mit dem Substrat in die Formgebungsposition bewegt werden.

Im Weiteren ist es von Vorteil, wenn in den wenigstens zwei Bereichen des Substrates Medium derart auf das Substrat aufgebracht wird, dass Außenflächen der wenigstens zwei jeweils vom Medium gebildeten Formkörper beabstandet zueinander angeordnet sind. Gemäß dieser speziellen Ausführungsform der Erfindung werden somit wenigstens zwei asymmetrische Linsen auf einem Substrat hergestellt, die sich nicht berühren und dadurch symmetrisch oder asymmetrisch zueinander angeordnet werden können. Auf diese Weise lassen sich wiederum entweder wenigstens zwei unregelmäßig auf einem Substrat verteilte oder eine Mehrzahl von linienförmig oder in Form eines Arrays angeordnete Linsen aus einem polymerhaltigen Material herstellen.

Eine weitere spezielle Ausbildung der Erfindung sieht vor, dass das Substrat mit dem darauf angeordneten, zumindest noch nicht vollständig getrockneten oder ausgehärteten Medium zumindest zeitweise während oder nach der Aufbringung des Mediums in eine Drehbewegung versetzt wird. In diesem Zusammenhang ist es denkbar, dass ein Kippen und eine Drehbewegung zumindest teilweise nacheinander erfolgen.

Generell ist es in diesem Zusammenhang denkbar, dass der Drehpunkt oder die Drehachse durch den wenigstens einen aus polymerhaltigem Medium gebildeten Formkörper verläuft oder aber ein Abstand zwischen dem Schwerpunkt eines Formkörpers aus polymerhaltigem Material und einer Drehachse, um die die Drehbewegung erfolgt, vorgesehen ist. Vorzugsweise wird die Drehgeschwindigkeit der Drehbewegung verändert. So ist es etwa denkbar, dass die Drehgeschwindigkeit in Abhängigkeit des Fortschritts einer Austrocknung oder Aushärtung des polymerhaltigen Materials gezielt verändert wird. Beispielsweise ist es denkbar, zu Beginn des Formgebungsprozesses die Drehgeschwindigkeit gering zu halten und diese in Abhängigkeit des zeitlichen Verlaufs des Aushärtungs- oder Austrocknungsfortschritts des polymerhaltigen Materials zu steigern. Ebenso ist es denkbar, die Lage eines Drehpunkts oder einer Drehachse, um den oder die die Drehbewegung erfolgt, gezielt zu verändern. Entsprechende Veränderungen der Drehgeschwindigkeit oder der Lage eines Drehpunktes oder einer Drehachse erfolgen bevorzugt mithilfe einer Steuereinheit, die entsprechende Veränderungen unter Berücksichtigung des Fortschrittes eines Austrocknungs- oder Aushärtungsprozesses des polymerhaltigen Materials und/oder der herzustellenden asymmetrischen Linsenform vornimmt.

Eine entsprechende Steuereinheit ist derart eingerichtet, dass in Abhängigkeit des Aushärtungs- oder Austrocknungsfortschritts und/oder der gewünschten Linsenform geeignete Steuersignale zur Ansteuerung der Bewegung des Substrats mit dem darauf befindlichen Medium in die Formgebungsposition erzeugt werden. Diese Steuersignale können auf der Grundlage von durch einen Nutzer eingegebenen oder in einem Datenspeicher hinterlegten Daten oder mithilfe von Sensoren aufgenommenen Messwerten erzeugt werden. Auf vorteilhafte Weise ist es in diesem Zusammenhang denkbar, dass mithilfe von Sensoren die Bewegung des Substrats mit dem darauf befindlichen Medium, und zwar gleichgültig ob es sich um eine Kipp- oder eine Drehbewegung handelt, erfasst wird, und/oder der Festigkeitsgrad des polymerhaltigen Mediums gemessen wird.

In einer besonders geeigneten Ausführungsform der Erfindung wird das Medium zur Aushärtung und/oder Trocknung vor, während oder nach der Bewegung des Substrats in die Formgebungsposition zumindest zeitweise mit UV-Licht oder sichtbarem Licht bestrahlt wird. In Abhängigkeit des gewählten Mediums kann dessen Bestrahlung auch mit elektromagnetischer Strahlung, die eine oder auch wenigstens zwei gezielt ausgewählte Wellenlängen aufweist, erfolgen. Gemäß einer ganz besonderen Ausführungsform der Erfindung erfolgt die Bestrahlung mit elektromagnetischer Strahlung mit einer Wellenlänge die kleiner als 380 nm ist. Hierbei ist es generell denkbar, dass eine entsprechende Bestrahlung nur zeitweise oder in bestimmten Zeitintervallen erfolgt.

Weiterhin ist es auf besonders geeignete Weise denkbar, die Bestrahlung zunächst mit einer ersten, vergleichsweise kurzwelligen Strahlung durchzuführen und anschließend mit einer zweiten Strahlung, deren Wellenlänge größer ist, fortzusetzen. In diesem Fall könnte mit der ersten Strahlung zunächst eine Polymer-Oberflächen-Modifizierung erfolgen, während später das im Inneren befindliche Medium mithilfe der zweiten, langwelligeren Strahlung gehärtet wird. So könnte nach erfolgter Polymer-Oberflächen-Modifizierung das im Inneren befindliche elastische Medium auf geeignete Weise verformt und die gewünschte asymmetrische Linsenform erzeugt werden.

In einer weiteren speziellen Ausgestaltung der Erfindung ist vorgesehen, dass das polymerhaltige Medium vor Einleitung der Bewegung in die Formgebungsposition aus einem festen Zustand in einen fließfähigen Zustand, vorzugsweise durch einen Schmelzvorgang, überführt wird. In diesem Zusammenhang ist es etwa denkbar, dass eine Linse oder ein Linsenarray, die oder das bereits in zumindest weitgehend ausgehärtetem Zustand auf einem Substrat angeordnet ist, zunächst zumindest teilweise aufgeschmolzen und dann durch Kippen oder eine Drehbewegung in eine Formgebungsposition überführt wird. Insbesondere ist es denkbar, im Wege eines Druckverfahrens oder durch Abformtechnik hergestellte symmetrische Linsen und/oder Linsenarrays mittels Einbringung von thermischer Energie zunächst zu erweichen und anschließend durch Einsatz des erfindungsgemäßen Verfahrens in die gewünschte Form zu bringen. Im Weiteren ist es denkbar, dass die wenigstens eine aus einem polymerhaltigen Medium gebildete asymmetrische Linse nach Abschluss des Aushärtens und/oder Austrocknens mit wenigstens einem Wiederaufschmelz- und/oder Ätzschritt bearbeitet wird. Mit einem entsprechend ausgewählten geeigneten Bearbeitungsschritt ist es möglich, Oberflächenstrukturen und somit Linsen, die über spezifische Eigenschaften verfügen, herzustellen. Alternativ oder in Ergänzung ist es denkbar, geeignete mechanische oder optische Bearbeitungsverfahren zu verwenden, um auf der Oberfläche der ausgehärteten oder ausgetrockneten Linsen geeignete optische Strukturen, beispielsweise Prismen oder Gitter zu erzeugen.

Ferner kann es von Vorteil sein, wenn der Bereich des Substrats, auf den das Medium aufgebracht wird, vor Aufbringung des Mediums oberflächenbehandelt wird. Eine Oberflächenbehandlung kann wahlweise durch Behandlung bzw. Bearbeitung der Oberfläche und/oder durch Aufbringen eines geeigneten Fluids erfolgen. In diesem Zusammenhang ist es denkbar, dass die Substratoberfläche in dem Bereich, in dem das Medium aufgebracht werden soll, hinsichtlich seiner Hydrophobie gezielt eingestellt wird. Gemäß einer besonderen Weiterbildung wird die Oberfläche des Substrates durch gezielte Einstellung des Grades der Hydrophobie modifiziert, indem zum Beispiel PTFE (Polytetrafluorpolyethylen), HMDS (Hexalmethyldisilizan) und/oder TMSDEA (Trimethylsilyldiethylamine) auf die Oberfläche aufgebracht wird. Alternativ oder ergänzend ist es denkbar, die Substratoberfläche durch unterschiedliche Strukturierung zu modifizieren, um beispielsweise gezielt einen Randwinkel einzustellen, sodass hierdurch die Lichtverteilung der asymmetrischen Linse auf ein gewünschtes Maß einstellbar ist.

Durch die Modifizierung der Substratoberfläche mithilfe geeigneter hydrophober Materialien, wie etwa PTFE, oder hydrophiler Materialien, durch eine geeignete Strukturierung der Substratoberfläche, mittels der auch hydrophobe Fläche realisierbar sind, durch Oberflächenmodifizierung mittels Plasmabehandlung und/oder durch geeignete Gestaltung einer LED-Einfassung auf der Substratoberfläche, können somit gezielt Verbesserungen, insbesondere indem die Oberfläche bedarfsgerecht hydrophobiert oder hydrophiliert wird, erzielt werden. In diesem Zusammenhang generiert gemäß einer speziellen Ausführungsform der Erfindung aufgrund der Modifikation der Substratoberfläche das Polymer beim Kontakt mit der Substratoberfläche einen derart großen Abrollwinkel, dass die Einzellinsen in einem Linsenarray separiert werden.

Die Erfindung betrifft im Weiteren eine Leuchteinheit mit einer Lichtquelle, die wenigstens bereichsweise von einer nach dem Verfahren gemäß zumindest einem der zuvor beschriebenen Ausführungsbeispiele hergestellten asymmetrischen Linse überdeckt ist. Die Leuchteinheit zeichnet sich somit dadurch aus, dass eine speziell hergestellte, asymmetrische Polymerlinse, die spezielle Eigenschaften in Bezug auf die Lichtformung bzw. Lichtleitung aufweist, verwendet wird, um die Abstrahlcharakteristik der Leuchteinheit gezielt einzustellen. Vorzugsweise verfügt die Lichtquelle über wenigstens eine LED und/oder ein Lichtleiterende, die oder das von einer entsprechend hergestellten asymmetrischen Polymerlinse zur gezielten Einstellung der Abstrahlcharakteristik überdeckt ist.

Gemäß einer ganz besonderen Ausführungsform sind wenigstens zwei Lichtquellen vorgesehen und derart ausgeführt sowie angeordnet, dass das von den asymmetrischen Linsen, die den Lichtquellen in Strahlrichtung nachgeschalt sind, ausgesendete Licht gezielt einen bestimmten Raumbereich verstärkt ausleuchtet und/oder in zumindest einem Bereich gemischt wird.

Gemäß der speziellen Ausführungsform zur Mischung von Licht sind die asymmetrischen Linsen derart hergestellt, dass das die jeweilige Linse verlassende Licht in einen Bereich gelangt, in dem dieses mit dem von einer anderen Linse ausgesandten Licht gemischt wird. Auf diese Weise können mit verhältnismäßig einfachen Mitteln gezielt Lichteffekte, insbesondere unterschiedliche Farbgestaltungen realisiert werden. Die erfindungsgemäß ausgeführte Leuchteinheit bietet somit die Möglichkeit, eine effektive, schräge Lichtverteilung für eine LED oder ein LED-Array zu realisieren, wobei die jeweiligen Polymerlinsen während der Trocknungs- oder Aushärtungsphase bevorzugt schräggestellt und/oder in eine Drehbewegung versetzt werden.

Ebenso ist es denkbar, mit Hilfe des erfindungsgemäßen Verfahrens Linsen oder Mikrolinsen herzustellen, die in optische Systeme eingebaut oder auf LEDs aufgeklebt werden. In einer weiteren bevorzugten Ausgestaltung ist weiterhin vorgesehen, das transparente Substrate für Linsenarrays erzeugt werden.

Im Übrigen sind mit dem erfindungsgemäßen Verfahren hergestellte asymmetrische Linsen geeignet, um für Chip-on-Board (CoB)-Anwendungen, bei denen LED-Chips direkt auf eine Leiterplatte aufgesetzt und mit Hilfe von Bonddrähten kontaktiert werden, eingesetzt zu werden, und zwar unabhängig davon, ob die Gehäuse Keramik oder Leiterplattenmaterial aufweisen. Im Weiteren können erfindungsgemäß hergestellte asymmetrische Linsen auch unabhängig von der jeweiligen optischen oder lichttechnischen Lösung direkt auf ein Halbleitersubstrat und/oder auf einen Lichtleiter aufgebacht werden. Ferner sind die erfindungsgemäßen Linsen besonders geeignet, um in Sensoren verwendet zu werden.

Gemäß einer weiteren besonderen Ausführungsform der Erfindung verfügt eine Leuchteinheit über eine außermittig in Bezug auf ein Gehäuse, also mit unterschiedlichem Abstand zu einer Rand des Gehäuses, angeordnete Lichtquelle, insbesondere eine LED, die von einer erfindungsgemäß ausgeführten asymmetrischen Linse überdeckt wird. Mit Hilfe einer derart ausgebildeten Leuchteinheit lässt sich eine asymmetrische Lichtlenkung bzw. Ausleuchtung bei gleichzeitig vergleichsweise geringen Effizienzverlusten realisieren. Wesentlich an dieser technischen Lösung ist somit, dass die Lichtquelle innerhalb eines in einem Substrat ausgebildeten Hohlraums, der beispielsweise ein Gehäuse für die LED bildet, außermittig, also mit einem Versatz zum Mittelpunkt angeordnet ist. Gegenüber bekannten Lösungen zur asymmetrischen Ausleuchtung eines Raumbereichs, die über eine außermittig angeordnete Lichtquelle und eine symmetrische Linse verfügen, zeichnet sich die Leuchteinheit gemäß dieser Ausführungsform durch eine vergleichsweise hohe Effizienz aus, da die sonst üblichen Abschattungseffekte verhindert oder zumindest minimiert werden können, insbesondere dann, wenn zusätzlich wenigstens ein Reflektor im Strahlengang vorgesehen ist. Es können auf diese Weise Leuchteinheiten, die sich durch eine vergleichsweise effiziente Weitwinkellichtverteilung auszeichnen, realisiert werden.

Im Folgenden wird die Erfindung ohne Beschränkung des allgemeinen Erfindungsgedankens anhand spezieller Ausführungsformen und unter Bezugnahme auf die Figuren näher erläutert. Dabei zeigen:

Fig. 1:    Leuchteinheit mit LED und einer asymmetrisch ausgebildeten Mikrolinse zur asymmetrischen Lichtverteilung;

Fig. 2:    Grafische Darstellung der asymmetrischen Lichtverteilung durch eine auf einer LED angeordnete asymmetrische Mikrolinse;

Fig. 3:    Herstellung asymmetrischer oder asphärischer Mikrolinsen auf einem Substrat unter Einsatz eines Kippverfahrens;

Fig. 4:    Herstellung asymmetrischer oder asphärischer Mikrolinsen auf einem Substrat unter Einsatz eines Kippverfahrens während des Dispensprozesses;

Fig. 5:    Herstellung asymmetrischer Mikrolinsen einem auf Substrat mit LED bei zusätzlichem Einsatz einer Oberflächenmodifizierung;

Fig. 6:    Herstellung einer Mikrolinse auf einem Substrat mit LED unter Einsatz eines Spinnverfahrens;

Fig. 7:    Herstellung asymmetrischer Mikrolinsen unterschiedlicher Form auf einem Substrat mit LED unter Einsatz eines Spinnverfahrens;

Fig. 8:    Vergleich zwischen konventionell und erfindungsgemäß hergestellter Mikrolinse für die gezielte Gestaltung der Lichtverteilung von Leuchteinheiten mit LED;

Fig. 9:    Lineare und/oder arrayförmige Anordnung einer Mehrzahl von erfindungsgemäß hergestellte Mikrolinsen auf einem Substrat;

Fig. 10:    Asymmetrisches Mikrolinsenarray für eine homogene Ausleuchtung hergestellt durch Spinnverfahren mit Separation der Linsen durch Oberflächenmodifizierung;

Fig. 11:    Asymmetrisches Mikrolinsenarray für eine schräge Ausleuchtung hergestellt durch Kippverfahren mit einer Separation durch Mikrostrukturen;

Fig. 12:    Farbgestaltung mithilfe eines asymmetrischen Mikrolinsenarray unterschiedlich farbiger LEDs sowie

Fig. 13:    Formung von Polymerlinsen unter Einsatz eines Kippverfahrens.

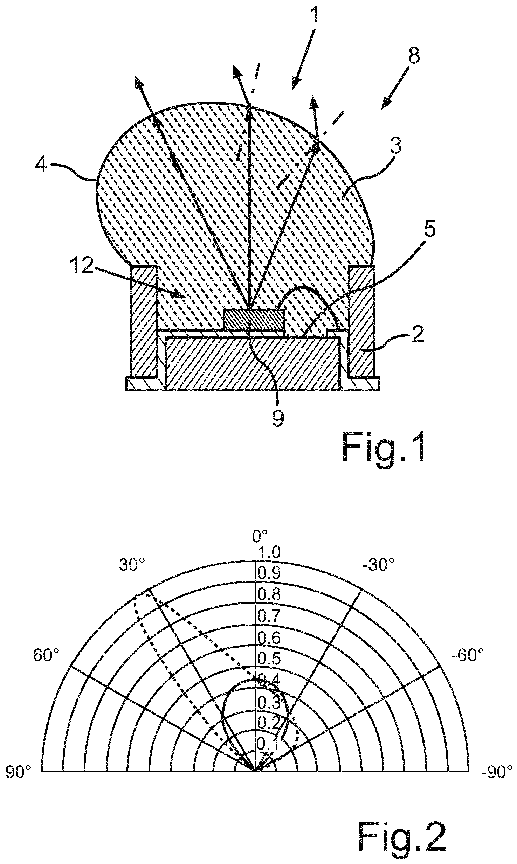

Fig. 1 zeigt zunächst eine Leuchteinheit 8, die über eine auf einem Substrat 2, das allgemein ein Halbleitersubstrat oder einen für die Aufbringung eines ungehäusten Halbleiterchips geeigneten Träger (Chip-on-Board-Technologie (CoB)) aufweisen kann, angeordnete LED als Lichtquelle 9 verfügt. Die Lichtquelle 9 ist von einer asymmetrischen Linse 1, hier in miniaturisierter Form als Mikrolinse ausgeführt, überdeckt. In dem in Fig. 1 gezeigten Ausführungsbeispiel verfügt das Substrat 2 über einen Hohlraum 12, der die Lichtquelle 9 in Form einer ungehäusten LED bzw. eines ungehäuster LED-Chips aufnimmt und der das Gehäuse der Lichtquelle 9 bildet.

Wesentlich für die in Fig. 1 gezeigte Linse 1 ist, dass bei deren Herstellung ein polymerhaltiges Medium 3 in dem Bereich, in dem sich die LED auf dem Substrat 2 befindet, auf die Oberfläche 5 des Substrats 2 aufgebracht wurde, wobei mit dem Medium 3 sowohl der im Substrat 2 gebildete Hohlraum 12 ausgefüllt als auch oberhalb des Substrats 2 ein Formkörper 4 ausgebildet wurde. Generell ist es denkbar, dass die Verfahrensschritte Auffüllen des Hohlraums 12 sowie Ausbilden eines Formkörpers 4 als einstufiger oder zweistufiger Herstellungsprozess, unter Umständen sogar unter Einsatz von Medien 3 mit unterschiedlichen Eigenschaften, ausgeführt werden. Mithilfe eines zweistufigen Herstellungsprozesses könnte eine Linse mit besonders hoher Effizienz hergestellt werden, während ein einstufiger Herstellungsvorgang insbesondere im Hinblick auf die Wirtschaftlichkeit der Linsenherstellung vorteilhaft ist.

Zur Herstellung der gewünschten Linse wurde das Substrat 2 gemeinsam mit der LED und dem darauf angeordneten Medium 3 durch eine Kippbewegung mit einem Kippwinkel zwischen 30° und 60°, wobei der Kippwinkel zwischen einer in Lotrichtung verlaufenden Geraden und einem senkrecht auf die Substratoberfläche stehenden Normalenvektor angeordnet ist, in eine Formgebungsposition überführt. In dieser Formgebungsposition wurde eine Kraft in das noch nicht ausgehärtete oder ausgetrocknete, somit noch formbare polymerhaltige Medium 3 eingeleitet, deren Wirkrichtung von der Lotrichtung, also der Richtung der Erdbeschleunigung, abwich. Während des Aushärtungs- bzw. Austrocknungsprozesses wirkte diese gezielt eingeleitete Kraft auf das noch formbare Polymer ein, sodass sich schließlich nach abgeschlossener Aushärtung bzw. Trocknung die in Fig. 1 dargestellte Linsenform einstellte.

Aufgrund der speziellen Ausgestaltung der Linse 1 emittiert die Leuchteinheit 8 Licht nicht gleichmäßig in alle Raumrichtungen, sondern das Licht wird, wie durch die Pfeile dargestellt, gezielt in hierfür ausgewählte Bereiche abgestrahlt. Die in Fig. 1 dargestellte Leuchteinheit 8 verfügt somit aufgrund des Einsatzes einer speziell hergestellten asymmetrischen Polymerlinse 1 über eine besondere Abstrahlcharakteristik, die sich durch eine asymmetrische Lichtverteilung auszeichnet.

In Fig. 2 ist die Abstrahlcharakteristik der in Fig. 1 gezeigten Leuchteinheit 8 grafisch dargestellt, und es wird deutlich, dass das von der LED emittierte Licht aufgrund der speziellen Linsenform der aus polymerhaltigem Material hergestellten asymmetrischen Linse 1 nur in einen bestimmten Raumbereich abgestrahlt wird.

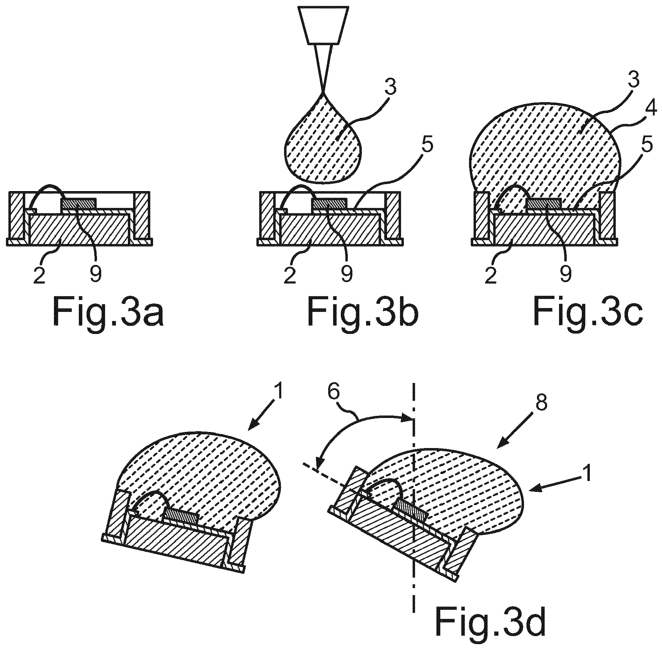

Fig. 3 zeigt den Verfahrensablauf bei der Herstellung einer Leuchteinheit 8 mit LED als Lichtquelle 9, die von einer asymmetrischen miniaturisierten Linse 1 aus einem polymerhaltigen Medium 3 überdeckt wird. In Fig. 3 a) ist der Ausgangszustand gezeigt, nämlich das Substrat 2, das ein Halbleitermaterial aufweist und ein Gehäuse bildet, in dem eine elektrisch leitfähig kontaktierten LED, die die Lichtquelle 9 darstellt, angeordnet ist.

In einem ersten Verfahrensschritt gemäß Fig. 3 b) wird ein polymerhaltiges Medium 3, insbesondere ein optischer Kunststoff, wie beispielsweise Polyurethan (PUR oder PU), Silikon, Polymethylmethacrylat (PMMA) oder ein besonders geeignetes Polymer der Firma resintec GmbH, nämlich Guronic, eine weichelastische Vergussmasse bestehend aus zwei modifizierten Kohlenwasserstoffharzen, oder ResPUR-OT, ein optischer Hochleistungskunststoff auf Basis eines Zwei-Komponenten-Polyurethans, mithilfe einer Dispensvorrichtung in flüssigem Zustand auf den Bereich des Halbleitersubstrats 2 aufgebracht, in dem sich die LED der Leuchteinheit 8 befindet. Fig. 3 zeigt hierbei eine Ausführungsform des erfindungsgemäßen Verfahrens, bei dem das noch nicht ausgehärtete oder ausgetrocknete, und damit noch formbare Medium 3 aus polymerhaltigem Material unter Ausbildung eines Formkörpers 4 auf das Substrat 2 aufgebracht wird, während sich das Substrat 2 noch in der Ausgangsposition befindet. Nach Aufbringen des polymerhaltigen Mediums 3 bildet dieses den in Fig. 3 c) gezeigten, noch vergleichsweise einfach formbaren Formkörper 4 aus.

In dem in Fig. 3 d) gezeigten Verfahrensschritt wird das Substrat 2 gemeinsam mit dem darauf aufgebrachten Medium 3 aus polymerhaltigem Material in eine Formgebungsposition bewegt, wobei eine Kippbewegung ausgeführt wird. In Abhängigkeit des gewählten Kippwinkels 6, also dem Winkel, der sich zwischen der Ebene, in der sich die Substratoberfläche, auf der das polymerhaltige Medium 3 angeordnet ist, befindet und einer durch die Substratoberfläche 5 verlaufenden Lotrechten, also einer in Richtung der Erdbeschleunigung verlaufenden Geraden einstellt, können unterschiedliche Linsenformen hergestellt werden. Wird das Substrat 2, das hier wiederum als Träger mit einem Gehäuse für die Lichtquelle 9 ausgeführt ist, gemeinsam mit dem darauf aufgebrachten Polymermedium 3 in die in Fig. 3 d) gezeigte Positionen überführt, so werden asymmetrische miniaturisierte Linsen 1 durch Kippung hergestellt.

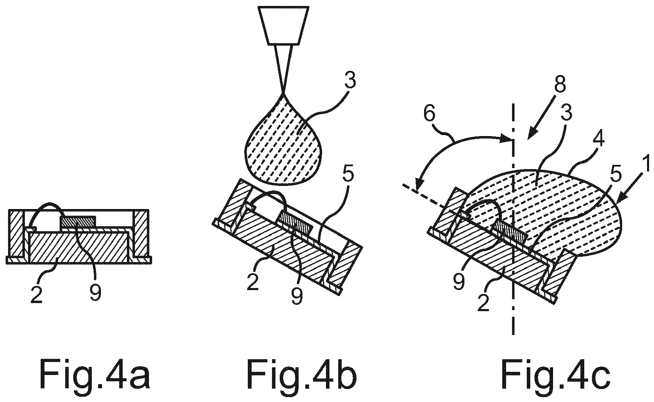

Fig. 4 zeigt abermals die Herstellung einer asymmetrischen miniaturisierten Linse 1 auf einem Substrat 2 aus Halbleitermaterial mit einer LED bei Einsatz eines Kippverfahrens, wobei das Kippen gemäß der in Fig. 4 gezeigten Ausführungsform bereits während des Dispensvorganges, also während des Aufbringen des polymerhaltigen, noch nicht ausgehärteten oder ausgetrockneten, und somit formbaren Mediums 3 auf die Substratoberfläche 5 erfolgt. Fig. 4 b) ist in diesem Zusammenhang zu entnehmen, dass das Substrat 2 mit der LED bereits gekippt ist, bevor das polymerhaltige Medium 3 zur Ausbildung eines Formkörpers 4 die Oberfläche 5 des Substrats 2 berührt. Ergänzend zeigt Fig. 4 c) den Zustand der Leuchteinheit 8, in dem sich diese befindet, nachdem das polymerhaltige Medium 3 auf die gekippte Substratoberfläche 5 aufgebracht wurde. Mithilfe des in Fig. 4 dargestellten Herstellungsverfahren lässt sich wiederum eine asymmetrische Mikrolinse 1 auf einem Substrat 2 mit einer LED als Lichtquelle 9, das entweder ein Halbleitersubstrat 2 oder, wie hier gezeigt, einen Träger mit einem Gehäuse (CoB-Technologie) aufweist, herstellen.

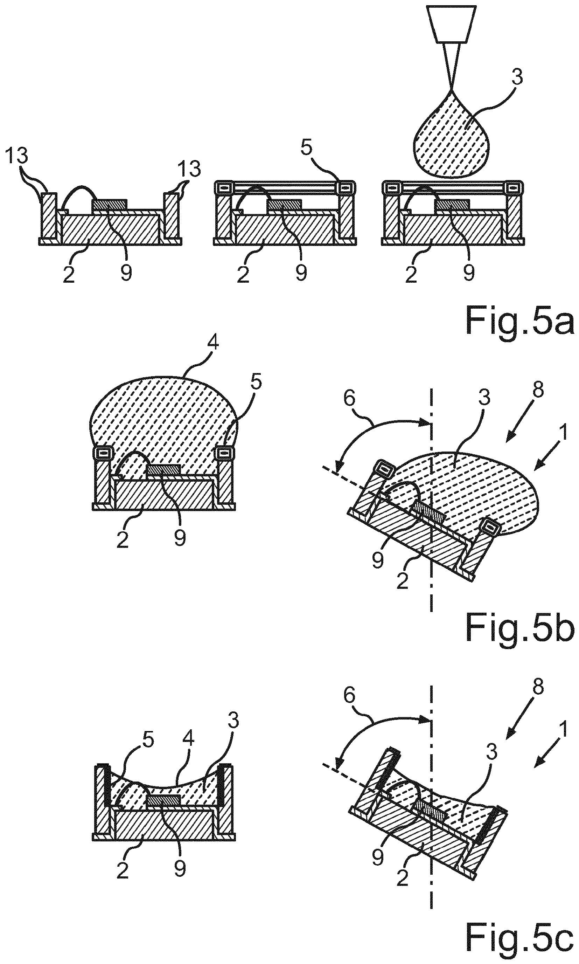

In Fig. 5 ist ergänzend die Herstellung einer asymmetrischen Linse 1 auf einem Substrat 2 mit LED als Lichtquelle 9 dargestellt, wobei die Oberfläche 5 des Substrats 2 oder das Substrat 2 vor Aufbringung des polymerhaltigen Mediums 3 zusätzlich auf geeignete Weise modifiziert wird. Eine Oberflächenmodifizierung 13 kann, wie dies schematisch in Fig. 5 a) gezeigt ist, wahlweise auf der Grundfläche, auf wenigstens einer der Innenseitenwände oder auf der Grundfläche und wenigstens einer der Seitenwände des Substrates sowie auf den Außenseiten erfolgen.

Auf diese Weise wird auch sichergestellt, dass selbst bei einem Kippen des Substrats 2 mit noch nicht vollständig verfestigtem polymerhaltigem Medium 3 zumindest nahezu kein Medium auf der hydrophob modifizierten Außenwand anhaftet.

Gemäß dem in Fig. 5 gezeigten Ausführungsbeispiel wird die Oberfläche 5 des Substrats 2 vor Aufbringung des polymerhaltigen Mediums 3 hydrophobiert, sodass sich eine modifizierte Substratoberfläche 5 einstellt. Die Modifizierung der Substratoberfläche 5 wird hierbei derart durchgeführt, dass sich ein gezielt ausgewählter Kontaktwinkel einstellt und ein Überschreiten des Abrollwinkels des Polymers verhindert wird.

Durch Aufbringen des polymerhaltigen Mediums 3 auf einen Bereich, in dem die Substratoberfläche 5 modifiziert ist, kann auf der Substratoberfläche 5 ein Formkörper 4 ausgebildet werden, der über ganz spezielle Eigenschaften verfügt, insbesondere nicht auf der Oberfläche 5 des Substrats 2 verläuft oder eine Kugelform annimmt und sich trotzdem mit der Oberfläche vollflächig verbindet.

Fig. 5b) zeigt wiederum den Verfahrensschritt, in dem das Substrat 2 mit der LED und dem auf der hydrophoben Substratoberfläche 5 angeordneten Formkörper 4 aus polymerhaltigem Medium 3 um einen geeigneten Kippwinkel 6 zur Erzeugung einer asymmetrischen miniaturisierten Linse 1 gekippt wird.

Im Vergleich hierzu zeigt Fig. 5 c) den Verfahrensschritts des gemeinsamen Kippens von Substrat 2 und Medium 3, bei einer Substratoberfläche 5, hier der Innenwand, die vor dem Aufbringen des Mediums 3 hydrophiliert wurde.

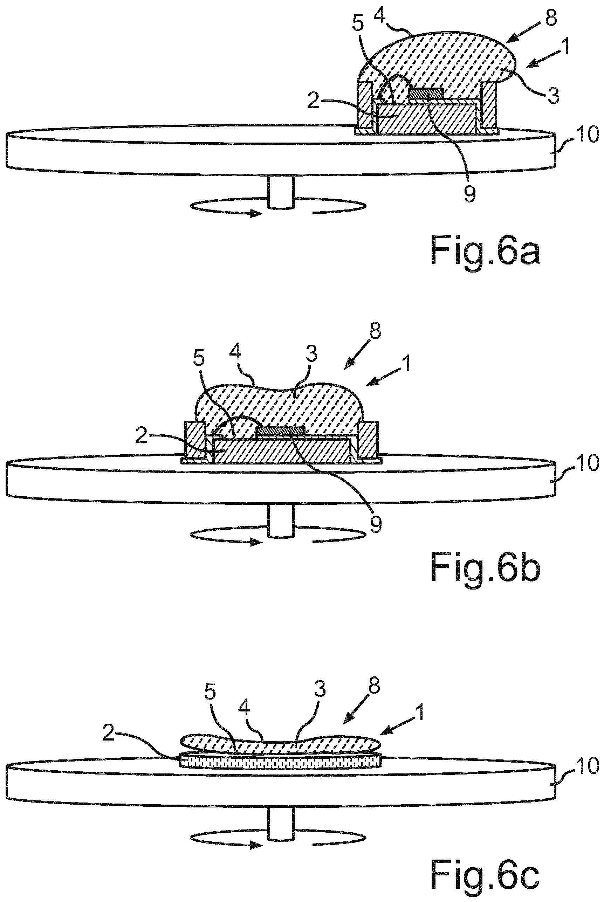

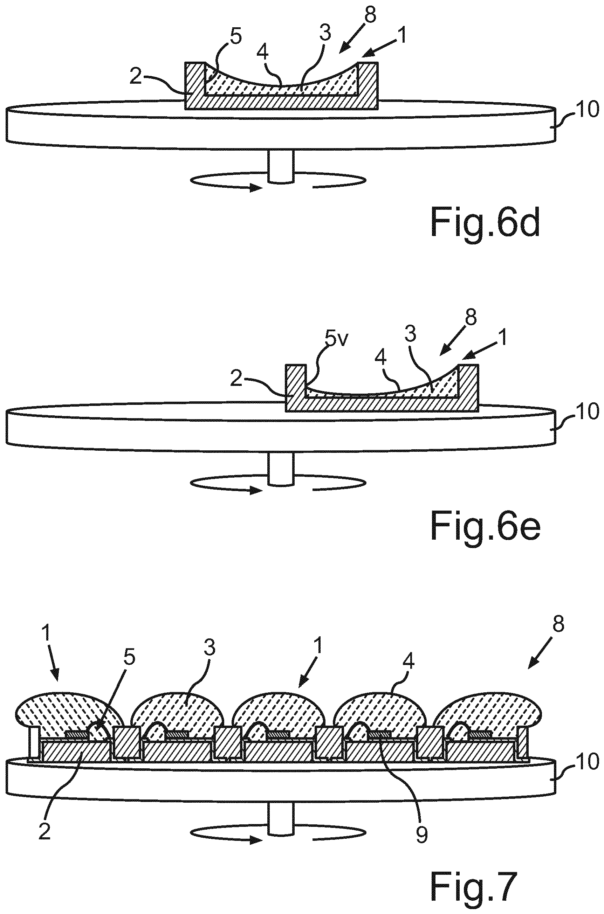

In Fig. 6 ist eine alternative Ausführungsform der Erfindung dargestellt, bei der ein noch nicht vollständig getrocknetes oder ausgehärtetes Medium 3 unter Ausbildung eines Formkörpers 4 auf ein Substrat 2 mit darauf als Lichtquelle 9 angeordneter LED aufgebracht wird und mithilfe eines Spinverfahrens, bei dem das Substrat 2 mit dem darauf angeordneten polymerhaltigen Medium 3 in eine Drehbewegung versetzt wird, eine asymmetrische Linse hergestellt wird. Wesentlich an der in Fig. 6 gezeigten speziellen Ausführungsform des erfindungsgemäßen Verfahrens ist, dass das Substrat 2 mit dem darauf angeordneten polymerhaltigen Medium 3 nach dessen Aufbringung in eine Drehbewegung um eine Rotationsachse versetzt wird.

In diesem Zusammenhang zeigt Fig. 6 a) eine spezielle Ausführungsform, bei der das Substrat 2 mit dem darauf angeordneten Medium 3 derart auf einer Drehscheibe 10 angeordnet ist, dass zwischen der Drehachse, um die die Drehbewegung erfolgt, und dem Substrat 2 mit dem darauf angeordneten Formkörper 4 aus polymerhaltigem Medium 3 ein Abstand vorhanden ist. Aufgrund der Drehbewegung und der hierdurch auf das noch nicht vollständig getrocknete oder ausgehärtete polymerhaltige Medium 3 wirkenden Zentrifugalkraft bewegt bzw. verformt sich das auf dem Substrat 2 angeordnete polymerhaltige Medium 3 zumindest teilweise nach außen. Daher bildet sich die in Fig. 6 a) gezeigte asymmetrische Linsenform auf dem Substrat 2 aus.

Im Vergleich zu der in Figur 6 a) gezeigten Ausführungsform wird das Substrat 2 mit dem darauf angeordneten polymerhaltigen Medium 3 gemäß dem in Fig. 6 b) dargestellten Ausführungsbeispiel zentrisch zur Rotationsachse angeordnet, sodass die Rotationsachse senkrecht zur Substratoberfläche 5 und durch den Schwerpunkt des aus polymerhaltigem Medium 3 gebildeten Formkörpers 4 verläuft. Die Drehbewegung bewirkt auch in diesem Fall die Verformung des noch nicht vollständig ausgehärteten oder ausgetrockneten polymerhaltige Mediums 3, wobei sich allerdings, wie in Fig. 6 c) deutlich zu sehen, eine asphärisch konvexe Linse 1 ausbildet. Gemäß der dargestellten Ausführungsform wird ein Substrat 2, das wenigstens bereichsweise ein transparentes Material aufweist, verwendet.

Während sich gemäß der in Fig. 6 d) gezeigten Ausführungsform unter Einsatz des Spinverfahrens eine asphärische oder sphärische symmetrisch konkave Polymerlinse herstellen lässt sich mit der in Fig. 6 e) gezeigten Anordnung eine asphärische oder sphärische asymmetrisch konkave Polymerlinse 1 herstellen. Um entsprechende Linsenformen erzeugen zu können, wird die Substratoberfläche 5 vor Aufbringung des Mediums 3 derart modifiziert, dass die Substratoberfläche 5 wenigstens bereichsweise hydrophil wird.

Fig. 7 zeigt wiederum ein Ausführungsbeispiel, bei dem das bereits zuvor erläuterte Spinverfahren zur Herstellung von miniaturisierten Linsen 1, auch Mikrolinsen genannt, zum Einsatz kommt. Gemäß dem in Fig. 7 gezeigten Ausführungsbeispiel werden gleichzeitig eine Mehrzahl von Linsen aus noch nicht ausgehärtetem oder ausgetrocknetem polymerhaltigem Medium 3 auf der Oberfläche 5 eines Substrats 2 ausgebildet, die während der Formgebungsphase um eine Drehachse gedreht werden. Aufgrund des unterschiedlichen Abstandes der einzelnen auf einem Halbleitersubstrat 2 ausgebildeten Formkörper zur Drehachse wirken auf diese unterschiedlich großen Zentrifugalkräfte. Aus diesem Grund wird in der Mitte wiederum eine asphärische Linse ausgebildet, während die äußeren Linsen 1 asymmetrisch ausgeformt werden. Der Grad der Asymmetrie der einzelnen Linsen 1 variiert hierbei mit der Größe des Abstandes von der Drehachse. Mithilfe des erfindungsgemäßen Verfahrens zur Herstellung asymmetrischer Linsen 1 kann somit, wie in Fig. 7 gezeigt, auf vergleichsweise einfache Weise eine geeignet ausgebildete Anordnung von Linsen 1 und oder Leuchteinheiten 8 mit entsprechenden Linsen 1 hergestellt werden.

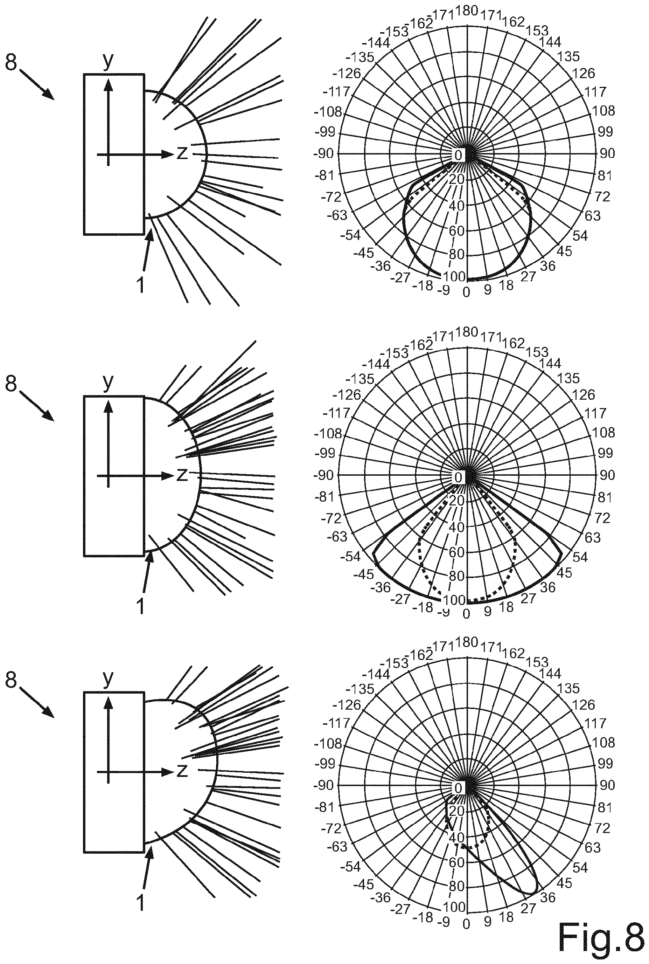

Fig. 8 zeigt in den Ansichten a), b) und c) jeweils mithilfe des erfindungsgemäßen Verfahrens hergestellte Leuchteinheiten 8 mit LEDs als Lichtquellen 9, die in einem im Substrat 2 ausgebildeten rechteckigen Gehäuse angeordnet sind und die über erfindungsgemäß hergestellte miniaturisierte Linsen 1 verfügen. Neben den Leuchteinheiten 9 ist jeweils grafisch die Abstrahlcharakteristik der entsprechend ausgeführten Leuchteinheiten 9 dargestellt. Fig. 8 veranschaulicht hierbei, wie mithilfe des erfindungsgemäßen Verfahrens auf vergleichsweise einfache Weise gezielt Leuchteinheiten 9 mit miniaturisierten, asymmetrischen Linsen aus polymerhaltigem Medium 3, die über spezielle Abstrahlcharakteristika verfügen, hergestellt werden können.

In Fig. 8 a) ist in diesem Zusammenhang eine sphärische Linse zum Vergleich dargestellt. Fig. 8 b) zeigt eine asphärische Linse und Fig. 8 c) eine asymmetrische Linse, wie sie bevorzugt für eine schräge Ausleuchtung verwendbar ist.

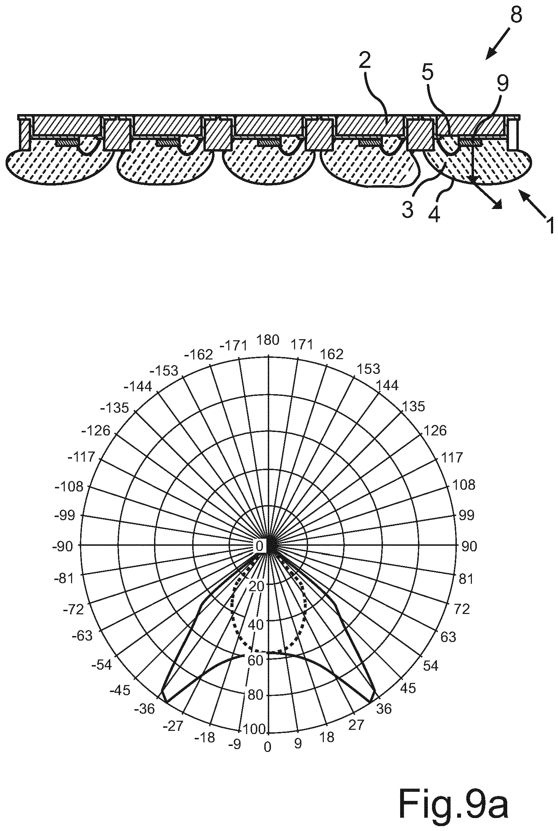

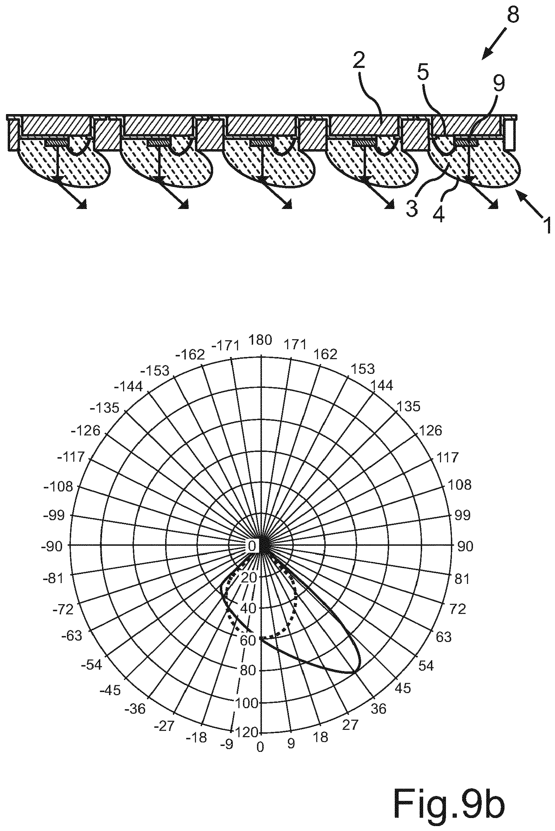

Im Weiteren zeigt Fig. 9 in den Ansichten a) und b) unterschiedliche lineare Mikrolinsensysteme, wie sie mit den zuvor erläuterten Verfahren hergestellt werden können. Wesentlich an der in Fig. 9 a) und c) gezeigten Ausführungsform ist, dass die gezeigten Linsenformen durch eine geeignete Dreh- oder Schleuderbewegung oder Kippung erzeugt werden.

Die in Fig. 9 a) dargestellte Anordnung von Linsen 1 kann auf bevorzugte Weise mit einem Verfahren, wie es im Zusammenhang mit der Fig. 7 erläutert wurde, hergestellt werden. Die grafische Darstellung der Abstrahlcharakteristik verdeutlicht wiederum, dass mit der gezeigten linearen oder zeilenförmigen Linsenanordnung ganz gezielt ausgewählte Bereiche besonders ausgeleuchtet werden. Dies wird erreicht, indem mittig wiederum eine asphärisch symmetrische Linse 1 angeordnet ist, während beidseitig dieser asphärisch symmetrischen Linse 1 wiederum asymmetrische Linsen oder asymmetrisch und asphärische Linsen, die unterschiedliche Asymmetrien aufweisen, angeordnet sind.

Auch das in Fig. 9 b) gezeigte Mikrolinsenarray lässt sich ebenfalls bevorzugt mit einem Verfahren, wie es im Zusammenhang mit der Fig. 7 erläutert wurde, herstellen. Insbesondere lassen sich so Mikrolinsenarrays mit einer bedarfsangepassten Abstrahlcharakteristik realisieren. Dieses verdeutlicht wiederum die grafische Darstellung der Abstrahlcharakteristik der Linsenanordnung. Mit der Anordnung von Linsen gemäß Fig. 9 b) lässt sich eine schräge Ausleuchtung realisieren.

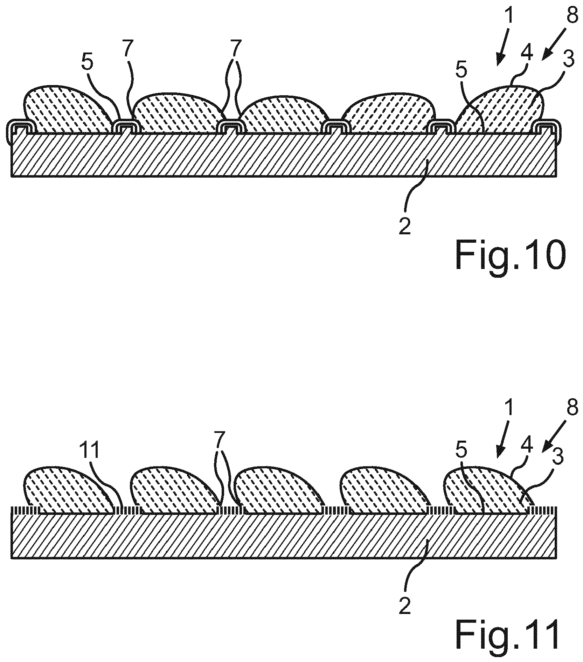

Im Weiteren zeigt Fig. 10 nochmals ein asymmetrisches Mikrolinsenarray für eine homogene Ausleuchtung, wie es beispielsweise durch das Spinnverfahren gemäß Fig. 7 hergestellt wurde. Die Separation der einzelnen Mikrolinsen 1 wird durch eine geeignete Oberflächenmodifizierung des Substrates 2, sicherstellt, sodass die Außenflächen 7 der einzelnen, aus polymerhaltigem Medium 3 gebildeten Formkörper 4 beabstandet zueinander auf der Oberfläche 5 des in diesem Fall transparenten Substrats 2 angeordnet sind.

In Fig. 11 ist ein asymmetrisches Mikrolinsensystem für eine schräge Ausleuchtung dargestellt. Das gezeigte asymmetrische Mikrolinsenarray wird bevorzugt durch ein Kippverfahren hergestellt. In diesem Fall erfolgt die Separation der einzelnen Mikrolinsen 1 nicht, wie in Fig. 10 gezeigt, durch eine Oberflächenmodifizierung, sondern es werden gezielt geeignete Mikrostrukturen 11 in einem Substrat 2, hier einem transparenten Material, wie etwa Glas, entweder durch ein additives Verfahren oder durch Ätzen hergestellt.

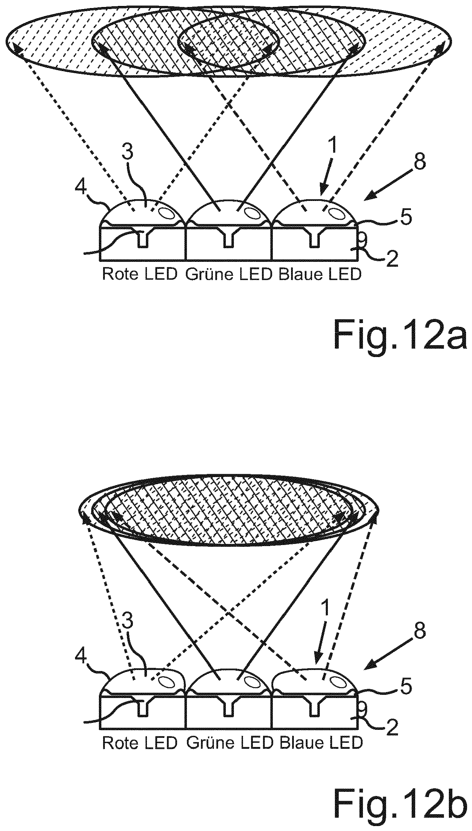

Fig. 12 zeigt in den Ansichten a) und b) jeweils eine Anordnung von drei Leuchteinheiten 8, die über eine LED als Lichtquelle 9 und eine oberhalb der LED angeordnete, mit dem erfindungsgemäßen Verfahren hergestellte Linse 1 verfügen. Die drei LEDs emittieren Licht unterschiedlicher Farbe, nämlich rotes, grünes oder blaues Licht.
Gemäß dem in Fig. 12 a) gezeigten Ausführungsbeispiel sind die Mikrolinsen als symmetrische Linsen ausgeführt. Das von den LEDs emittierte Licht wird von den einzelnen im Strahlengang den LEDs nachgeordneten Linsen 1 aus polymerhaltigem Medium 3 derart gelenkt, dass einzelne Bereiche geschaffen werden, in denen Licht unterschiedlicher Farbe gemischt wird. So entstehen etwa Außenbereiche, in die lediglich rotes und blaues Licht abgestrahlt wird, während im Inneren Bereiche geschaffen werden, in denen grünes, blaues und rotes Licht in unterschiedlichen Intensitäten gemischt wird. Die gezeigte technische Lösung zeigt eine Weißlichtausleuchtung mit störenden Farbrändern.

Fig. 12 b) zeigt wiederum eine Anordnung von Leuchteinheiten 8, von denen die beiden äußeren über asphärisch asymmetrische Linsen verfügen, während die mittige Leuchteinheit 9 über eine sphärisch symmetrische Linse 1 verfügt. Auch bei dem in Fig. 12 b) gezeigten Ausführungsbeispiel entstehen wiederum Bereiche, in denen Licht unterschiedlicher Farbe gemischt wird. Die gezeigte technische Lösung kann für eine homogene Weißlichtausleuchtung verwendet werden.

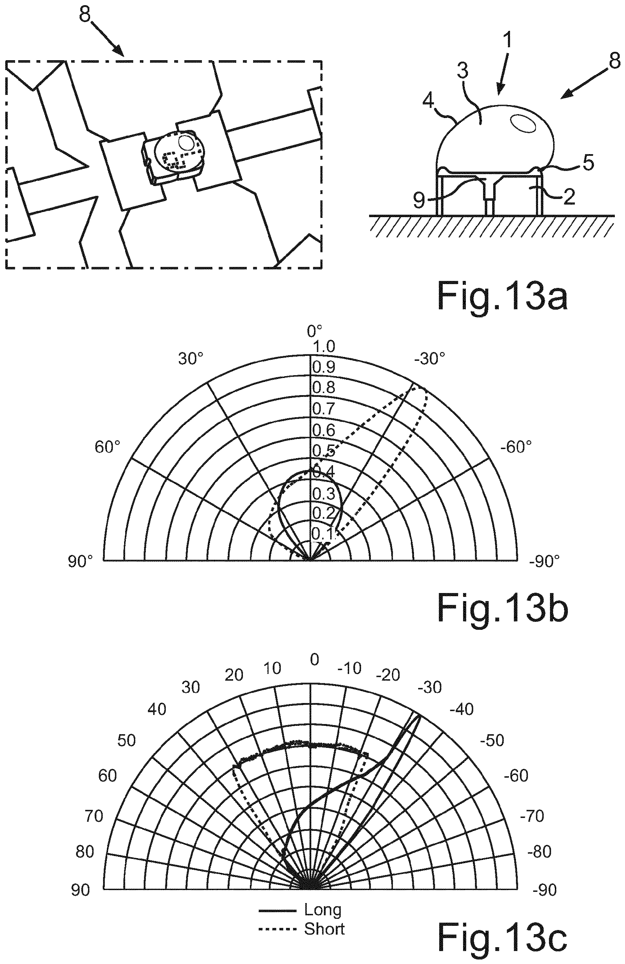

Im Weiteren zeigt Fig. 13 in der Ansicht a) eine mithilfe des erfindungsgemäßen Verfahrens hergestellte CoB-LED der Firma EPIGAP Optronic GmbH mit asymmetrische Polymerlinse 1, wobei die spezielle Linsenform durch Kippen auf bevorzugte Weise mit einem Kippwinkel von 30 bis 60° des im Substrat 2 ausgebildeten CoB-Gehäuses gemeinsam mit dem aufgebrachten polymerhaltigen Medium 3, das aus hochtransparenten und temperaturstabilen Polyurethan der Firma resintec GmbH besteht, während des Austrocknens oder Aushärtens erzeugt wurde.
Die Oberseite der Substratoberfläche 5 wurde, der für die Aufbringung des polymerhaltigen Mediums 3 vorgesehen ist, noch vor der Aufbringung des Mediums mit PTFE beschichtet und die Aushärtung erfolgte bei einem bevorzugten Kippwinkel von 30 bis 60°, insbesondere von 40° bis 50°, besonders bevorzugt von etwa 45°, gegenüber der Lotrechten, also einer Geraden in Lotrichtung. Ergänzend hierzu zeigt Fig. 13 b) die Simulation der asymmetrischen Lichtstrahlen und Fig. 13 c) das dazugehörige Messergebnis der Lichtverteilung.

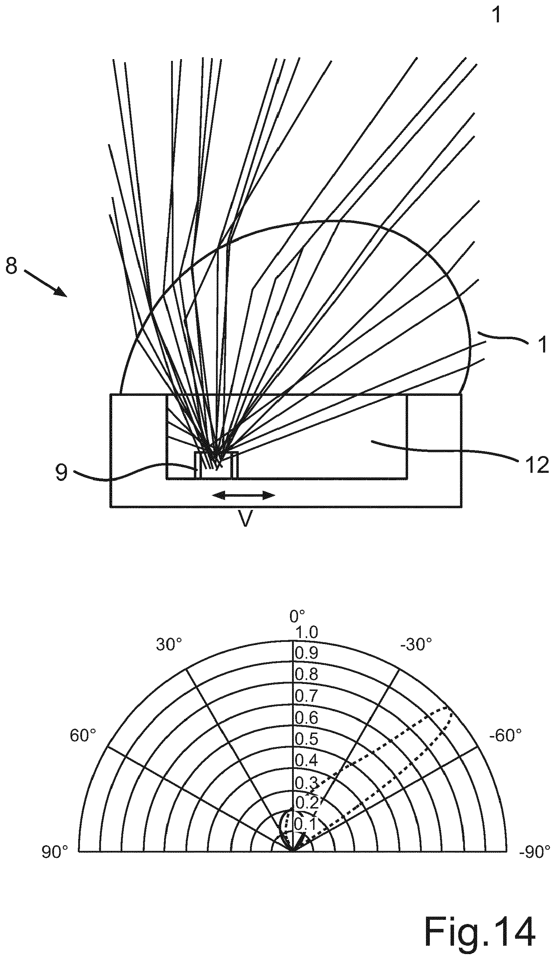

Weiterhin ist in Fig. 14 eine spezielle Ausgestaltung einer Leuchteinheit 8 dargestellt, die über eine erfindungsgemäß hergestellte asymmetrische Linse 1 verfügt. Wesentlich an der gezeigten technischen Lösung ist, dass die als Lichtquelle 9 verwendete LED innerhalb eines in einem Substrat 2 ausgebildeten Hohlraums 12, der ein Gehäuse für die LED bildet, außermittig, also mit einem Versatz V zum Mittelpunkt angeordnet ist. Mit Hilfe einer derartigen Anordnung einer LED in Kombination mit einer symmetrischen Linse wird bei bekannten Leuchteinheiten 8 eine asymmetrische Ausleuchtung realisiert. Nachteilig an einer derartigen Anordnung der LED ist jedoch, dass durch Abschattungen teilweise erhebliche Effizienzverluste hingenommen werden müssen. Wird, wie in Fig. 14 gezeigt, eine außermittig angeordnete LED als Lichtquelle 9 mit einer erfindungsgemäß hergestellten asymmetrischen Linse 1 kombiniert, können vergleichsweise effektive Weitwinkellichtverteilungen erzielt werden. Denkbar ist es in diesem Zusammenhang, die Effektivität durch Einsatz wenigstens eines Reflektors weiter zu verbessern.

Durch Wahl geeigneter Materialien und Herstellungsparameter, insbesondere durch Wahl eines geeigneten Kippwinkels zwischen 0° und 90°, kann auf die Form einer asymmetrischen Linse, die mit dem erfindungsgemäßen Verfahren hergestellt ist, gezielt Einfluss genommen werden. Zur Verwendung als Polymer erscheinen derzeit zwei Polymere der Firma resintec GmbH, nämlich einerseits Guronic, eine weichelastische Vergussmasse bestehend aus zwei modifizierten Kohlenwasserstoffharzen, und andererseits ResPUR-OT, ein optischer Hochleistungskunststoff auf Basis eines Zwei-Komponenten-Polyurethans, als besonders geeignet zur erfindungsgemäßen Herstellung asymmetrischer Polymerlinsen.
Im Weiteren kann die Form asymmetrischer Polymerlinsen durch Veränderung der Oberflächeneigenschaften des Substrats, auf das das zu formende Medium aufgebracht wird, gezielt beeinflusst werden. Für eine Oberflächenmodifikation bieten sich etwa Hexamethyldisilazan (HMDS), Trimethylsilylamine (TMSDEA), Polytetrafluorethylen (PTFE) oder Tetrahalogensilane, beispielsweise Trichlosilan, besonders an.

Zum Nachweis der Vorteile des erfindungsgemäßen Verfahrens wurden verschiedene Versuche durchgeführt, in denen die jeweils gewählten Versuchsparameter sowie die verwendeten Substrate und darauf aufgebrachten Polymeren verändert wurden. Um eine Vergleichbarkeit der Versuchsergebnisse herzustellen, wurde jeweils die Exzentrizität E der geometriebildenden Ellipse und die sich hieraus ergebende Asymmetrie der jeweils erzeugten Linse ermittelt.

Die jeweilige Exzentrizität E der geometriebildenden Ellipse wird wie folgt berechnet:

$$E = \sqrt{1 - \left(\frac{a}{b}\right)^2}$$

a- kleine Halbachse
b- große Halbachse der Ellipse

Hieraus ergibt sich als Bewertungsparameter gemäß der folgenden Berechnungsvorschrift ein Wert für die jeweilige Linsen-Asymmetrie:

$$A = E \sin w_e \cos w_e$$

$w_e$- Neigung der Hauptachse der elliptischen Linse.

Insgesamt haben die durchgeführten Versuche gezeigt, dass die effektivste Formgebung bei einer Neigung, also einem Kippwinkel von 45° erfolgt. Bei Neigungswinkeln von 0° bzw. 90° bilden sich Hauptachsenwinkel von $w_e$= 0° oder $w_e$= 90° bzw. es bilden sich symmetrische Linsen mit A = 0 aus.

In den folgenden Tabellen sind die einzelnen Versuchsergebnisse aufgeführt, wobei das noch nicht ausgehärtete Polymermaterial durch Dispens jeweils auf modifizierte Glasoberflächen, die als Substratoberflächen bereitgestellt wurden, erfolgte.

Die folgende Tabelle zeigt die Abhängigkeit der erzeugten Linsenform von der Oberflächenspannung bei Verwendung von ResPUR-OT bzw. Guronic der Firma resintec GmbH als Polymer:

| Material | Viskosität | Polymer Oberflächenspannung | Substrat Modifikation | Substrat Oberflächenspannung | Kipp-Winkel | a/b | E | $w_e$ | A | Linsenform (symmetrisch) |
|---|---|---|---|---|---|---|---|---|---|---|
| | (mPa×s) | dyn/cm | | dyn/cm | ° | | | ° | | |
| ResPUR-OT | 2000 | 50 | PTFE | 16 | 0 | 1 | 0 | 0 | 0 | |
| Guronic | 7000 | 40 | PTFE | 16 | 0 | 1 | 0 | 0 | 0 | |

Es zeigt sich, dass sich bei einer Erhöhung der Oberflächenspannung des Polymers der Randwinkel vergrößert, sodass insgesamt eine größere Linse, hier eine Linse, die einer Halbkugel angenähert ist, erzeugbar ist.

Die folgende Tabelle zeigt bei Verwendung von Guronic der Firma resintec GmbH als Polymer die Abhängigkeit der erzeugten Linsenform von der Oberflächenmodifizierung des Substrats. Für die Oberflächenmodifizierung wurde in einem ersten Versuch Polytetrafluorethylen (PTFE) und in einem zweiten Versuch Hexamethyldidilizan (HMDS) verwendet:

| Material | Viskosi-tät | Polymer Oberflä-chen-spannung | Substrat Modifi-kation | Substrat Oberflä-chen-spannung | Kipp-Win-kel | a/b | E | w_e | A | Linsenform (asymmetrisch) |
|---|---|---|---|---|---|---|---|---|---|---|
| | (mPa×s) | dyn/cm | | dyn/cm | ° | | | ° | | |
| Guronic | 7000 | 40 | PTFE | 16 | 50 | 0.65 | 0.8 | 50 | 0.38 | |
| Guronic | 7000 | 40 | HMDS | 35 | 50 | 0.42 | 0.9 | 78 | 0.18 | |

In diesem Versuch zeigte sich, dass je geringer die Oberflächenspannung des Substrates ist, desto größer wird die Asymmetrie (A) der Linse.

Die folgende Tabelle zeigt bei Verwendung von ResPUR-OT der Firma resintec GmbH als Polymer die Abhängigkeit der erzeugten Linsenform vom während der Härtung gewählten Kippwinkel:

| Material | Viskosi-tät | Polymer Oberflä-chen-spannung | Substrat Modifika-tion | Substrat Oberflä-chen-spannung | Kipp-Win-kel | a/b | E | w_e | A | Linsenform (asymmetrisch) |
|---|---|---|---|---|---|---|---|---|---|---|
| | (mPa×s) | dyn/cm | | dyn/cm | ° | | | ° | | |
| ResPUR-OT | 2000 | 50 | PTFE | 16 | 30 | 0.74 | 0.7 | 78 | 0.14 | |
| ResPUR-OT | 2000 | 50 | PTFE | 16 | 70 | 0.83 | 0.6 | 67 | 0.20 | |

In diesem Versuch zeigte sich, dass je kleiner der Kippwinkel gewählt wird, desto geringer wird die Asymmetrie (A) der erzeugten Linse.

Im Weiteren wurde ein Versuch zur Herstellung asymmetrischer Linsen auf CoB LEDs durchgeführt.

Die folgende Tabelle zeigt bei Verwendung von ResPUR-OT der Firma resintec GmbH als Polymer die Abhängigkeit der Form einer Linse auf einer LED mit Gehäuse von der jeweils für eine Linse verwendeten Menge bzw. des Volumens des Polymers bei gleichzeitiger Modifizierung der Oberfläche des Gehäuses mit Polytertafluorethylen (PTFE) oder Hexamethyldidilizan (HMDS)

| Material | Viskosi-tät | Polymer Oberflä-chen-spannung | Sub-strat Modifi-kation | Substrat Oberflä-chen-spannung | Kipp-Winkel | a/b | E | $w_e$ | A | Volu-men | Linsenform (asymmet-risch) |
|---|---|---|---|---|---|---|---|---|---|---|---|
| | (mPa×s) | dyn/cm | | dyn/cm | ° | | | ° | | µl | |
| ResPUR-OT | 2000 | 50 | PTFE | 16 | 50 | 1.05 / 1.30 | 0.59 | 60 | 0.26 | 6 | |
| ResPUR-OT | 2000 | 50 | PTFE | 16 | 50 | 1.10 / 1.43 | 0.64 | 60 | 0.28 | 7 | |
| ResPUR-OT | 2000 | 50 | HMDS | 35 | 50 | 0.84 / 1.22 | 0.73 | 70 | 0.23 | 4 | |

In diesem Versuch zeigte sich, dass je geringer das Dispens-Volumen (Bereich ≤ 10µl) gewählt wird, desto geringer wird die Asymmetrie (A) der hergestellten Linse. Ebenso zeigte sich, je geringer die Oberflächenspannung des Substrates ist, desto größer wird die Asymmetrie der hergestellten Linse.

Bezugszeichenliste

1 Linse
2 Substrat
3 Medium
4 Formkörper
5 Substratoberfläche
6 Kippwinkel
7 Formkörperaußenfläche
8 Leuchteinheit
9 Lichtquelle
10 Drehscheibe
11 Mikrostruktur
12 Hohlraum
13 Oberflächenmodifizierung

V Versatz

**Patentansprüche**

1. Verfahren zur Herstellung asymmetrischer Linsen (1), bei dem wenigstens ein polymerhaltiges Medium (3) in einem für einen Durchtritt oder eine Emission von Strahlung vorgesehenen Bereich eines Substrats (2) auf das Substrat (2) unter Bildung eines Formkörpers (4) aufgebracht wird und das polymerhaltige Medium zumindest zeitweise getrocknet und/oder gehärtet wird,
**dadurch gekennzeichnet, dass** das Substrat (2) bevor, während und/oder nachdem das noch nicht vollständig getrocknete oder ausgehärtete Medium (3) auf das Substrat (2) aufgebracht wird, derart mit dem Substrat gekippt wird, dass ein zwischen einer in Lotrichtung verlaufenden Geraden und einem senkrecht zur Substratoberfläche ausgerichteter Normalenvektor angeordneter Kippwinkel einen Wert zwischen 0° und 90° annimmt oder das Substrat gemeinsam mit dem Medium wenigstens zeitweise in eine Drehbewegung versetzt wird.

**2.** Verfahren nach Anspruch 1,
**dadurch gekennzeichnet, dass** der Kippwinkel einen Wert zwischen 30° und 60°, insbesondere zwischen 40° und 50°, annimmt.

**3.** Verfahren nach Anspruch 1 oder 2,
**dadurch gekennzeichnet, dass** das Substrat wenigstens zeitweise gemeinsam mit dem darauf aufgebrachten Substrat um eine senkrecht zur Substratoberfläche angeordnete Drehachse gedreht wird.

**4.** Verfahren nach einem der Ansprüche 1 bis 3,
**dadurch gekennzeichnet, dass** der Kippwinkel (6) in Abhängigkeit einer gewünschten Abstrahlcharakteristik der Linse (1) eingestellt wird.

**5.** Verfahren nach einem der vorangehenden Ansprüche,
**dadurch gekennzeichnet, dass** in wenigstens zwei Bereichen des Substrates (2) Medium (3), das gleiche oder unterschiedliche Eigenschaften aufweist, unter Ausbildung von Formkörpern (4) auf das Substrat (2) aufgebracht wird und die wenigstens zwei jeweils vom Medium (3) gebildeten Formkörper (4) gemeinsam mit dem Substrat (2) gekippt oder gedreht werden.

**6.** Verfahren nach Anspruch 5,
**dadurch gekennzeichnet, dass** in wenigstens zwei Bereichen des Substrates (2) Medium (3) derart auf das Substrat (2) aufgebracht wird, dass Außenflächen (7) der wenigstens zwei jeweils vom Medium gebildeten Formkörper (4) beabstandet zueinander angeordnet sind.

**7.** Verfahren nach einem der vorangehenden Ansprüche,
**dadurch gekennzeichnet, dass** eine Drehgeschwindigkeit der Drehbewegung verändert wird.

**8.** Verfahren nach einem der vorangehenden Ansprüche,
**dadurch gekennzeichnet, dass** eine Lage eines Drehpunkts, um den die Drehbewegung erfolgt, verändert wird.

**9.** Verfahren nach einem der vorangehenden Ansprüche,
**dadurch gekennzeichnet, dass** der Kippwinkel, eine Geschwindigkeit, mit der das Substrat gemeinsam mit dem Medium gekippt wird, oder eine Geschwindigkeit der Drehbewegung in Abhängigkeit der gewünschten Abstrahlcharakteristik der Linse (1) gewählt und/oder zumindest zeitweise verändert wird.

**10.** Verfahren nach einem der vorangehenden Ansprüche,
**dadurch gekennzeichnet, dass** in wenigstens zwei Bereichen eines Substrates (2) ein Medium jeweils unter Ausbildung von Formkörpern (4) auf das Substrat aufgebracht und derart angeordnet wird, dass Schwerpunkte der jeweils von einem Medium (3) gebildeten Formkörper (4) unterschiedlich weit von einem Drehpunkt, um den die Drehbewegung erfolgt, entfernt sind.

**11.** Verfahren nach einem der vorangehenden Ansprüche,
**dadurch gekennzeichnet, dass** das Medium (3) zur Aushärtung und/oder Trocknung während oder nach dem Kippen oder Drehen zumindest zeitweise mit elektromagnetischer Strahlung mit einer Wellenlänge, die kleiner als 380 nm ist, bestrahlt wird.

**12.** Verfahren nach einem der vorangehenden Ansprüche,
**dadurch gekennzeichnet, dass** das Medium (3) vor dem Kippen und/oder Drehen durch einen Schmelzvorgang aus einem festen Zustand in einen fließfähigen Zustand überführt wird.

**13.** Verfahren nach einem der vorangehenden Ansprüche,
**dadurch gekennzeichnet, dass** der Bereich des Substrats (2), auf den das Medium (3) aufgebracht wird, vor Aufbringung des Mediums (3) teilweise oder ganzflächig oberflächenbehandelt wird.

**14.** Sensor mit wenigstens einer Linse (1), die mit einem Verfahren nach einem der vorangehenden Ansprüche hergestellt ist.

**15.** Leuchteinheit (8) mit einer Lichtquelle (9), die wenigstens bereichsweise von einer nach einem Verfahren gemäß der Ansprüche 1 bis 13 hergestellten asymmetrischen Linse (1) überdeckt ist.

**16.** Leuchteinheit nach Anspruch 15,
**dadurch gekennzeichnet, dass** die Lichtquelle (9) eine LED, eine Chipintegrierte Strahlungsquelle und/oder ein Lichtwellenleiterende aufweist.

**17.** Leuchteinheit nach Anspruch 15 oder 16,
**dadurch gekennzeichnet, dass** wenigstens zwei Lichtquellen (9) vorgesehen und derart ausgeführt sowie angeordnet sind, dass das von den Lichtquellen (9) in Strahlrichtung nachgeschalteten asymmetrischen Linsen (1) ausgesendete Licht in zumindest einem Bereich gemischt wird.

Fig.1

Fig.2

Fig.3a

Fig.3b

Fig.3c

Fig.3d

Fig.4a   Fig.4b   Fig.4c

Fig.5a

Fig.5b

Fig.5c

Fig.6a

Fig.6b

Fig.6c

Fig.6d

Fig.6e

Fig.7

Fig.8

Fig.9a

Fig.9b

Fig.10

Fig.11

Rote LED  Grüne LED  Blaue LED

Fig.12a

Rote LED  Grüne LED  Blaue LED

Fig.12b

8

3 1 8

4

5

9 2

# Fig.13a

0°
1.0
30° 0.9 -30°
0.8
0.7
60° 0.6 -60°
0.5
0.4
0.3
0.2
0.1
90° -90°

# Fig.13b

20 10 0 -10 -20
30 -30
40 -40
50 -50
60 -60
70 -70
80 -80
90 -90

—— Long
······ Short

# Fig.13c

Fig.14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20180143414 A1
- US 20130056774 A1
- US 20070155033 A1
- EP 3460538 A1
- US 20060291065 A1

**In der Beschreibung aufgeführte Nicht-Patentliteratur**

- **UMUT T. SANLI.** 3D Nanoprinted Plastic Kinoform X-Ray Optics. *Advanced Materials,* 2018, vol. 30, 201802503